# EUROPEAN PATENT APPLICATION

(11) **EP 4 607 135 A2**
(43) Date of publication of application: **27.08.2025**
(21) Application number: 25187866.6
(22) Date of filing: 24.01.2024
(51) Int. Cl.: F28D 15/02

(54) **VAPOR CHAMBER AND DISPLAY DEVICE INCLUDING THE SAME**

(30) Priority: 07.02.2023 KR 20230015926
(62) Divisional of application: 24153602.8
(71) Applicant: Samsung Display Co., Ltd., Yongin-si, Gyeonggi-do 17113 (KR)
(72) Inventor: Jeong, Wee Joon, Yongin-si, Gyeonggi-do (KR); Kim, Yong Il, Yongin-si, Gyeonggi-do (KR); Park, Byoung Kyoo, Yongin-si, Gyeonggi-do (KR); Choi, Jang Un, Yongin-si, Gyeonggi-do (KR)
(74) Representative: Gulde & Partner

(57) **Abstract**

A display device includes a display panel, a driving board disposed on a side of the display panel, and a vapor chamber disposed between the display panel and the driving board, wherein the vapor chamber includes an external member, a first wick and a second wick which are disposed on at least parts of inner surfaces of the external member and face each other, a refrigerant which is contained in the external member, and a refrigerant dense part in which the refrigerant densely resides, and an area occupied by the first wick on the inner surfaces of the external member is greater than an area occupied by the second wick on the inner surfaces of the external member.

## Description

### BACKGROUND

### 1. Technical Field

The disclosure relates to a vacuum chamber and a display device including the same.

### 2. Description of the Related Art

As the information society has developed, the demand for display devices for displaying images has diversified. For example, display devices have been applied to various electronic devices such as smart phones, digital cameras, laptop computers, navigation systems, and smart televisions. Here, the display devices may be flat panel display devices such as a liquid crystal display (LCD) device, a field emission display (FED) device, or an organic light-emitting diode (OLED) display device.

Meanwhile, a display device may include a heat dissipation member for efficiently dissipating heat generated when the display panel thereof emits light. The display device may include a vapor chamber containing a refrigerant such as a phase-change material (PCM) as the heat dissipation member.

### SUMMARY

Aspects of the disclosure provide a vapor chamber capable of efficiently dissipating heat from a display panel and a driving board and a display device including the vapor chamber.

However, aspects of the disclosure are not restricted to those set forth herein. The above and other aspects of the disclosure will become more apparent to one of ordinary skill in the art to which the disclosure pertains by referencing the detailed description of the disclosure given below.

According to an aspect of the disclosure, there is provided a display device including a display panel, a driving board disposed on a side of the display panel, and a vapor chamber disposed between the display panel and the driving board, wherein the vapor chamber includes an external member, a first wick and a second wick which are disposed on at least parts of inner surfaces of the external member and face each other, a refrigerant which is contained in the external member, and a refrigerant dense part in which the refrigerant densely resides, and an area occupied by the first wick on the inner surfaces of the external member is greater than an area occupied by the second wick on the inner surfaces of the external member.

In an embodiment, the second wick may include a first portion which overlaps at least part of the driving board, and a second portion which does not overlap the driving board and is disposed below the first portion, and the second portion may be in direct contact with the refrigerant dense part.

In an embodiment, an area of the first portion may be greater than an area of the driving board.

In an embodiment, a width and a height of the first portion may be greater than a width and a height of the driving board, respectively, by as much as a first width, and the first width may be in a range of about 50 mm to about 150 mm, preferably 70 mm to about 130 mm, more preferably 90 mm to about 110 mm.

In an embodiment, a width of the second portion may be less than a width of the first portion.

In an embodiment, the external member may include a first-surface member and a second-surface member which are opposite to each other, and a third-surface member which intersects the first- and second-surface members, the first and second wicks may be disposed on first surfaces of the first- and second-surface members, respectively, the first wick may be disposed on the entire first surface of the first-surface member, and the second wick may be disposed on at least part of the first surface of the second-surface member and extends to be adjacent to the third-surface member.

In an embodiment, the external member may further include a fourth-surface member which is opposite to the third-surface member, the second wick may further include a third portion which is disposed between the first portion and the fourth-surface member, and the third portion may be not overlap the driving board and extends to be adjacent to the fourth-surface member.

In an embodiment, the first wick may overlap the entire display panel, and the second wick may overlap the entire driving board.

In an embodiment, wherein a width of the second wick may be substantially equal to a width of the driving board.

In an embodiment, a width of the second wick may be less than a width of the driving board.

According to an aspect of the disclosure, there is provided a vapor chamber including an external member including a first-surface member and a second-surface member which are opposite to each other, a first wick and a second wick disposed on first surfaces of the first- and second-surface members, respectively, the first and second wicks facing each other, a refrigerant contained in the external member, and a refrigerant dense part in which the refrigerant densely resides, wherein the first surface of the second-surface member includes a first area where the second wick is not disposed and a second area where the second wick is disposed, an area occupied by the first wick on the first surface of the external member is greater than an area occupied by the second wick on the first surface of the external member, and the first area adjoins left and right edges of the second area.

In an embodiment, the first area may adjoin the left and right edges and an upper edge of the second area.

In an embodiment, the first area may adjoin only the left and right edges of the second area.

In an embodiment, the refrigerant dense part may be in contact with the first and second wicks, the second wick may include a first portion which does not overlap the refrigerant dense part, and a second portion which overlaps at least part of the refrigerant dense part and is disposed below the first portion, left and right edges of the first portion may protrude beyond left and right edges of the second portion, respectively, and the first area may adjoin at least part of a lower edge of the first portion.

According to an aspect of the disclosure, there is provided a vapor chamber including an external member, a first wick and a second wick disposed on at least parts of inner surfaces of the external member, the first and second wicks facing each other, a refrigerant contained in the external member, and a refrigerant dense part in which the refrigerant densely resides, wherein an area occupied by the first wick on the inner surfaces of the external member is greater than an area occupied by the second wick on the inner surfaces of the external member.

In an embodiment, the second wick may include a first portion which does not overlap the refrigerant dense part, and a second portion which overlaps at least part of the refrigerant dense part and is disposed below the first portion.

In an embodiment, a width of the second portion is less than a width of the first portion.

In an embodiment, left and right edges of the first portion protrude beyond left and right edges of the second portion, respectively.

In an embodiment, the external member may include a first-surface member and a second-surface member which are opposite to each other, and a third-surface member which intersects the first- and second-surface members, the first and second wicks may be disposed on first surfaces of the first- and second-surface members, respectively, the first wick may be disposed on the entire first surface of the first-surface member, and the second wick may be disposed on at least part of the first surface of the second-surface member and extends to be adjacent to the third-surface member.

In an embodiment, the external member may further include a fourth-surface member which is opposite to the third-surface member, the second wick may further include a third portion which is disposed between the first portion and the fourth-surface member, and the third portion may be disposed above the first portion and extends to be adjacent to the fourth-surface member.

According to the aforementioned and other embodiments of the disclosure, heat from a display panel and a driving board can be efficiently dissipated.

It should be noted that the effects of the disclosure are not limited to those described above, and other effects of the disclosure will be apparent from the following description.

### BRIEF DESCRIPTION OF THE DRAWINGS

The above and other aspects and features of the disclosure will become more apparent by describing in detail embodiments thereof with reference to the attached drawings, in which:
FIG. 1 is a schematic exploded perspective view of a display device according to an embodiment of the disclosure;
FIG. 2 is a schematic plan view of the display device of FIG. 1;
FIG. 3 is a schematic diagram of the display device of FIG. 1;
FIG. 4 is a schematic side view of the display device of FIG. 1;
FIG. 5 is a schematic rear view of the display device of FIG. 1;
FIG. 6 is a schematic perspective view of a vapor chamber according to an embodiment of the disclosure;
FIG. 7 is a schematic exploded perspective view of the vapor chamber of FIG. 6;
FIG. 8 is a schematic cross-sectional view illustrating the vapor chamber of FIG. 6 and a driving board;
FIG. 9 is a schematic rear view illustrating the rear surface of a front member of the vapor chamber of FIG. 6;
FIG. 10 is a schematic front view illustrating the front surface of a rear surface of the vapor chamber of FIG. 6;
FIG. 11 is a schematic front view illustrating how a display panel according to an embodiment of the disclosure emits light;
FIGS. 12A and 12B are schematic cross-sectional views comparing a conventional vapor chamber and the vapor chamber of FIG. 6;
FIG. 13 is a graph showing the distribution of temperatures in a display device including the conventional vapor chamber;
FIG. 14 is a graph showing the distribution of temperatures in a display device including the vapor chamber of FIG. 6;
FIGS. 15A and 15B are enlarged graphs showing parts A and B of FIGS. 13 and 14, respectively;
FIG. 16 is a schematic exploded perspective view of a vapor chamber according to another embodiment of the disclosure;
FIG. 17 is a schematic front view illustrating the front surface of a rear member of the vapor chamber of FIG. 16;
FIG. 18 is a graph showing the distribution of temperatures depending on the width of a non-overlap area of a first portion of a second wick;
FIG. 19 is a schematic exploded perspective view of a vapor chamber according to another embodiment of the disclosure;
FIG. 20 is a schematic front view illustrating the front surface of a rear member of the vapor chamber of FIG. 19;
FIG. 21 is a schematic front view illustrating the front surface of a rear member of a vapor chamber according to another embodiment of the disclosure;
FIG. 22 is a schematic front view illustrating the front surface of a rear member of a vapor chamber according to another embodiment of the disclosure; and
FIG. 23 is a schematic front view illustrating the front surface of a rear member of a vapor chamber according to another embodiment of the disclosure.

### DETAILED DESCRIPTION OF THE EMBODIMENTS

The disclosure will now be described more fully hereinafter with reference to the accompanying drawings, in which embodiments of the disclosure are shown. This disclosure may, however, be embodied in different forms and should not be construed as limited to the embodiments set forth herein. Rather, these embodiments are provided so that this disclosure will be thorough and complete, and will filly convey the scope of the disclosure to those skilled in the art.

It will also be understood that when a layer is referred to as being "on" another layer or substrate, it can be directly on the other layer or substrate, or intervening layers may also be present. The same reference numbers and/or reference characters indicate the same components throughout the specification.

In the disclosure, the singular forms are intended to include the plural meanings as well, unless the context clearly indicates otherwise.

The term "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value."

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Embodiments of the disclosure will be described with reference to the attached drawings.

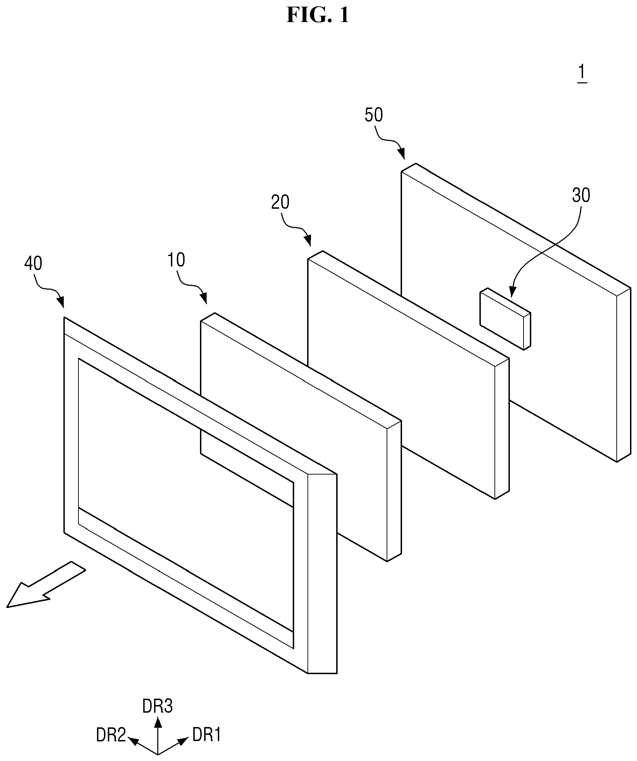

FIG. 1 is a schematic exploded perspective view of a display device according to an embodiment of the disclosure.

Referring to FIG. 1, a display device 1 may be applicable to, for example, a smartphone, a mobile phone, a tablet personal computer (PC), a personal digital assistant (PDA), a portable multimedia player (PMP), a television (TV), a gaming console, a wristwatch-type electronic device, a head-mounted display (HMD), a PC monitor, a laptop computer, a car navigation device, a car dashboard, a digital camera, a camcorder, an external billboard, an electronic display board, a medical device, an inspection device, or various home appliances (such as a refrigerator or a washing machine). The display device 1 may be, for example, a TV having a high or ultrahigh resolution (such as High Definition (HD), Ultra-High Definition (UHD), 4K or 8K).

The display device 1 may be classified in various manners depending on how it displays an image. The display device 1 may be, for example, an organic light-emitting diode (OLED) display device, an inorganic light-emitting diode (LED) display device, a quantum-dot light-emitting display device, a micro-LED display device, a nano-LED display device, a plasma display panel (PDP) device, a field emission display (FED) device, a cathode ray tube (CRT) display device, a liquid crystal display (LCD) device, or an electrophoretic display (EPD) device. The display device 1 may be, for example, an OLED display device, and an OLED display device will hereinafter be referred to as a display device unless specified otherwise. However, the disclosure is not limited to this, and various other display devices may also be applicable to the display device 1 without departing from the scope of the disclosure.

The display device 1 may include a display panel 10, a vapor chamber 20, a driving board 30, a front cover 40, and/or a rear cover 50.

The display panel 10 may be a self-luminous display panel. The display panel 10 may be a self-luminous display panel such as an organic light-emitting display panel, but the disclosure is not limited thereto. For example, the display panel 10 may also be applicable to various other types of display panels such as a liquid crystal display (LCD) panel, a quantum-dot organic light emitting display panel, a quantum-dot LCD panel, a quantum-nano-light-emitting display panel, or a micro-light-emitting diode (microLED).

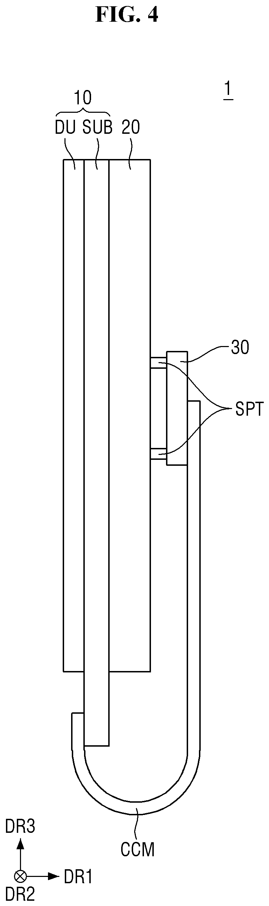

The display panel 10 may include a substrate SUB (see FIG. 4) and a display layer DU, which is disposed on the substrate SUB. The structure of the display panel 10 will be described below with reference to FIG. 4.

The vapor chamber 20 may dissipate heat from the display panel 10 and the driving board 30 to another space in the display device 1 or to the outside of the display device 1. For example, the vapor chamber 20 may dissipate heat from the display panel 10 and the driving board 30 to the space in the front cover 40 or the rear cover 50 or to the outside of the display device 1.

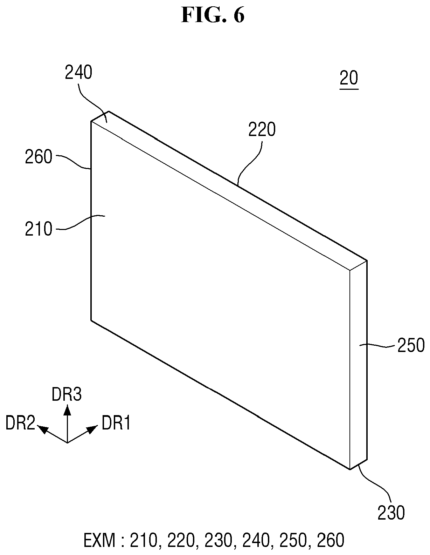

The vapor chamber 20 may be disposed between the display panel 10 and the driving board 30. The vapor chamber 20 will be described below with reference to FIG. 6.

The driving board 30 may include a processor, a memory, and/or an interface. The processor may include at least one of, for example, a central processing unit, an application processor, a graphics processing unit, an image signal processor, a sensor hub processor, and a communication processor. The processor or a communication module may be mounted on an electronic component such as an integrated circuit (IC) chip and may be disposed on the driving board 30.

Multiple electronic components may be disposed on the driving board 30, and some of the electronic components, such as a processor or an IC chip with a communication module mounted therein, may generate heat while operating. Heat generated by heating components may deteriorate their own performance or the power efficiency of the display device 1.

The driving board 30 may be positioned on an opposite side of the display panel 10 with the vapor chamber 20 disposed between the display panel 10 and the driving board 30. Heat generated from the driving board 30 may lower the emission efficiency of the display panel 10 or may accelerate the burn-in phenomenon of organic materials in an organic light-emitting display panel.

As the display device 1 may include a heat dissipation member such as the vapor chamber 20, the heat generated from the driving board 30 can be quickly distributed or released.

The front cover 40 and the rear cover 50 may surround the display panel 10, the vapor chamber 20, and the driving board 30. The front cover 40 and the rear cover 50 may protect the display panel 10, the vapor chamber 20, and the driving board 30 from external shock.

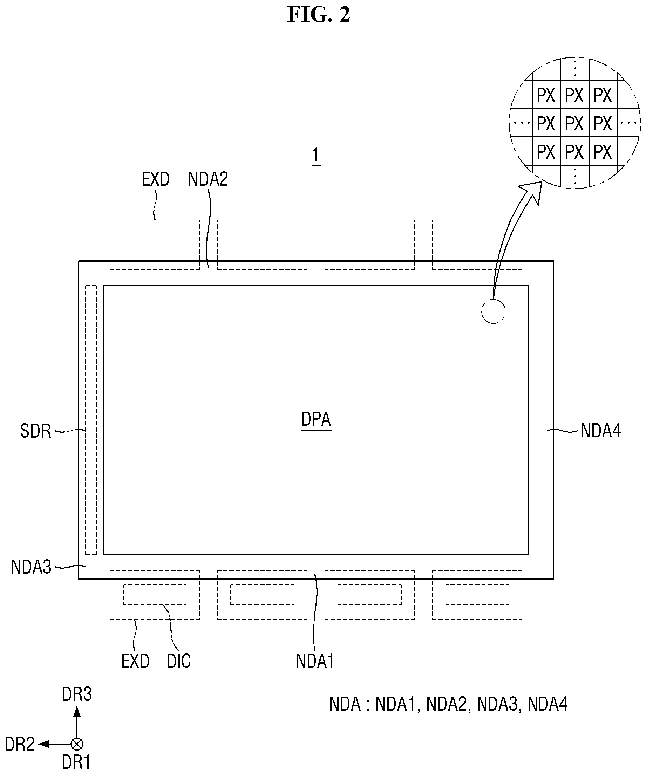

The front cover 40 may include a highly transparent material to be able to transmit light emitted from the display panel 10 therethrough. For example, the front cover 40 may include a polymer resin such as polyimide or glass. In another embodiment, the front cover 40 may include an opening in an area overlapping the display area DPA (see FIG. 2).

The term "front", as used herein, refers to a side as viewed in a first direction DR1, and the term "rear", as used herein, refers to a side as viewed in the opposite direction of the first direction DR1. For example, a direction from the display panel 10 to the driving board 30 refers to a front-to-rear direction.

FIG. 2 is a schematic plan view of the display device of FIG. 1.

Referring to FIG. 2, the display device 1 may have a square shape in a plan view. For example, the display device 1 may have a rectangular shape in a plan view, but the disclosure is not limited thereto.

In some embodiments, in a case where the display device 1 is a TV, the long sides of the display device 1 may be arranged in a horizontal direction, but the disclosure is not limited thereto. As another example, the long sides of the display device 1 may be arranged in a vertical direction, or the display device 1 may be rotatably installed so that the long sides thereof may be arranged horizontally or vertically.

The display device 1 may include a display area DPA and a non-display area NDA. The display area DPA may be an active area in which an image is displayed. The display area DPA may have a similar shape to the display device 1, for example, a rectangular shape, in a plan view, but the disclosure is not limited thereto.

The display area DPA may include pixels PX. The pixels PX may be arranged in row and column directions. The pixels PX may have a rectangular or square shape in a plan view, but the disclosure is not limited thereto. As another example, the pixels PX may have a rhombus shape having sides inclined with respect to the directions of the sides of the display device 1. The pixels PX may include pixels PX of various colors. In an example, the pixels PX may include a first-color pixel PX (e.g., a red pixel), a second-color pixel PX (e.g., a green pixel), and a third-color pixel PX (e.g., a blue pixel). The first-color pixel PX, the second-color pixel PX, and the third-color pixel PX may be alternately arranged in a stripe or PenTile^{™} fashion.

The non-display area NDA may be disposed around the display area DPA. The non-display area NDA may form the bezel of the display device 1. The non-display area NDA may surround the whole or part of the display area DPA.

In some embodiments, the display area DPA may have a rectangular shape, and the non-display area NDA may be disposed adjacent to the four sides of the display area DPA. For example, the non-display area NDA may include first, second, third, and fourth non-display areas NDA1, NDA2, NDA3, and NDA4, which are adjacent to a first long side (e.g., a lower side in FIG. 2), a second long side (e.g., an upper side in FIG. 2), a first short side (e.g., a left side in FIG. 2), and a second short side (e.g., a right side in FIG. 2), respectively, of the display device 1.

In the non-display area NDA, driving circuits or elements, which drive the display area DPA, may be disposed. For example, in the first and second non-display areas NDA1 and NDA2, pad parts may be provided on a display substrate of the display device 1, and external devices EXD may be mounted on pad electrodes of the pad parts. The external devices EXD may include circuit members CCM (see FIG. 4) that will be described below. Examples of the circuit members CCM may include connecting films, printed circuit boards (PCBs), driver integrated circuits (DICs), connectors, and wiring connecting films. For example, in the third non-display area NDA3, a scan driver SDR, which is formed directly on the display substrate of the display device 1, may be disposed.

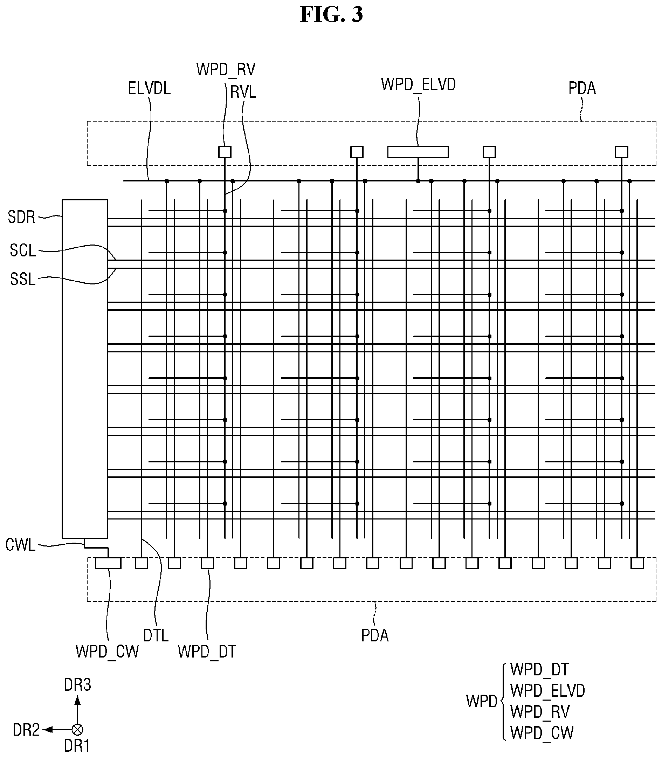

FIG. 3 is a schematic diagram of the display device of FIG. 1.

Referring to FIG. 3, lines may be disposed on the display substrate of the display device 1. The lines may include scan lines SCL, sensing signal lines SSL, data lines DTL, reference voltage lines RVL, and a first power supply line ELVDL.

The scan lines SCL and the sensing signal lines SSL may extend in a first direction DR1. The scan lines SCL and the sensing signal lines SSL may be connected to the scan driver SDR. The scan driver SDR may include driving circuits that consist of a circuit layer. The scan driver SDR may be disposed in the third non-display area NDA3, but the disclosure is not limited thereto. As another example, the scan driver SDR may be disposed in the fourth non-display area NDA4 or in the third and fourth non-display areas NDA3 and NDA4. The scan driver SDR may be connected to a signal connecting line CWL, and at least one end of the signal connecting line CWL may form a pad WPD_CW in the first non-display area NDA1 and/or the second non-display area NDA2 and may be connected to the external devices EXD of FIG. 2.

The first and second directions DR1 and DR2 may be horizontal directions and intersect each other. For example, the first and second directions DR1 and DR2 may be orthogonal to each other. A third direction DR3 may intersect the first and second directions DR1 and DR2 and may be, for example, a vertical direction orthogonal to the first and second directions DR1 and DR2. A side in each of the first, second, and third directions DR1, DR2, and DR3 may be referred to as a first side, and the other side in each of the first, second, and third directions DR1, DR2, and DR3 may be referred to as a second side.

The data lines DTL and the reference voltage lines RVL may extend in a second direction DR2, which intersects the first direction DR1. The first power supply line ELVDL may extend portions that extend in the second direction DR2. The first power supply line ELVDL may further include portions that extend in the first direction DR1. The first power supply line ELVDL may form a mesh structure, but the disclosure is not limited thereto.

Wire pads WPD may be disposed at least one end of each of the data lines DTL, the reference voltage line RVL and the first power supply line ELVDL. The wire pads WPD may be disposed in a pad portion PDA of the non-display area NDA. Wire pads WPD_DT (hereinafter the data pads WPD_DT) of the data lines DTL may be disposed in the pad portion PDA of the first non-display area NDA1, and wire pads WPD_RV (hereinafter the reference voltage pads WPD_RV) of the reference voltage lines RVL and a wire pad WPD_ELVD (hereinafter the first power supply pad WPD_ELVD) of the first power supply line ELVDL may be disposed in the pad portion PDA of the second non-display area NDA2. As another example, the data pads WPD_DT, the reference voltage pads WPD_RV and the first power supply pad WPD_ELVD may all be disposed in a same area, for example, the first non-display area NDA1. The external devices EXD of FIG. 1 may be mounted on the wire pads WPD. The external devices EXD may be mounted on the wire pads WPD via anisotropic conductive films or via ultrasonic bonding.

The pixels PX on the display substrate may include pixel driving circuits. The lines may pass by the pixels PX to apply driving signals to the pixel driving circuits. Each of the pixel driving circuits may include transistors and capacitors. The numbers of transistors and capacitors in each of the pixel driving circuits may vary.

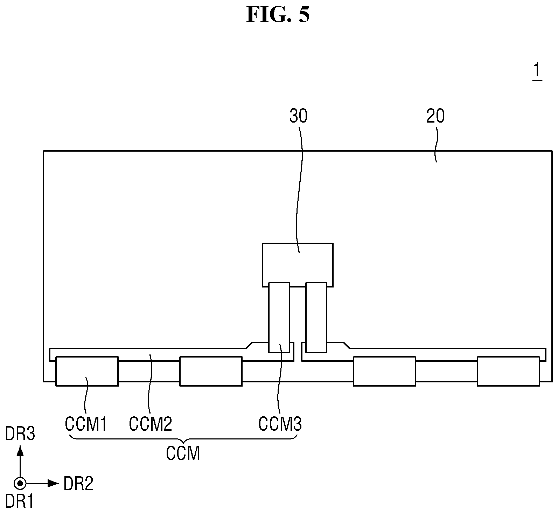

FIG. 4 is a schematic side view of the display device of FIG. 1. FIG. 5 is a schematic rear view of the display device of FIG. 1.

Referring to FIGS. 4 and 5, the display panel 10 may include the substrate SUB and the display layer DU.

The substrate SUB may be a base substrate or a base member. The substrate SUB may be a flexible substrate that is bendable, foldable, and/or rollable. For example, the substrate SUB may include a polymer resin such as polyimide, but the disclosure is not limited thereto. In another example, the substrate SUB may include a glass material or a metal material.

The display layer DU may include a thin-film transistor (TFT) layer (not illustrated), a light-emitting element layer (not illustrated), and a thin-film encapsulation (TFE) layer (not illustrated).

The TFT layer may include TFTs, which form the pixel circuits of the pixels, and the lines described above with reference to FIG. 2. The light-emitting element layer may include light-emitting elements, which include first electrodes, light-emitting layers, and second electrodes. The TFE layer may cover the top surface and the side surfaces of the light-emitting element layer and may protect the light-emitting element layer. The TFE layer may include at least one inorganic film and at least one organic film.

The circuit members CCM may be connecting films, DICs, connectors, PCBs, or flexible printed circuit boards (FPCBs). In a case where the circuit members CCM are flexible members, the circuit members CCM may be bent to face the rear surface of the substrate SUB.

The circuit members CCM may be mounted on the substrate SUB via the pad parts. First end portions of the circuit members CCM may be connected to the substrate SUB, and second end portions of the circuit members CCM may be connected to the driving board 30. As another example, in a case where circuit members CCM are provided, the end portions of each of the circuit members CCM may be connected to another circuit member CCM.

In some embodiments, the circuit members CCM may include first circuit members CCM1, second circuit members CCM2, and/or third circuit members CCM3.

First circuit members CCM1 may be formed and may be connected to the substrate SUB and the second circuit members CCM2. The first circuit members CCM1, which are flexible members, may be connecting films or FPCBs. The first circuit members CCM1 may be bent to place the second circuit members CCM2, the third circuit members CCM3, and the driving board 30 above the rear surface of the substrate SUB.

The second circuit members CCM2 may extend in the second direction DR2. The second circuit members CCM2 may include protruding portions, which extend in the third direction DR3. The second circuit members CCM2 may be connected to the first circuit members CCM1, on sides thereof that are opposite to the protruding portions, and the protruding portions of the second circuit members CCM2 may be connected to the third circuit members CCM3. In an embodiment, the second circuit members CCM2 may be PCBs.

The third circuit members CCM3 may extend in the third direction DR3. End portions of each of the third circuit members CCM3 may be connected to the second circuit members CCM2 and the driving board 30. The third circuit members CCM3 may be wiring connecting films. The position of the driving board 30 may be controlled by controlling the length of the third circuit members CCM3.

The circuit members CCM may be bent such that the driving board 30 may be disposed at the rear of the substrate SUB. In an embodiment, the driving board 30 may be spaced apart from the display panel 10. In a non-limiting example, the driving board 30 may be parallel to the display panel 30.

The driving board 30 may be positioned on an opposite side of the display panel 10 with the vapor chamber 20 being disposed between the display panel 10 and the driving board 30. In an embodiment, the driving board 30 may be disposed to overlap the middle of the vapor chamber 20. The driving board 30 may be supported and fixed by supports SPT, which are disposed between the vapor chamber 20 and the driving board 30.

The driving board 30 may include a processor, a memory, and/or an interface. The driving board 30 may include various electronic components such as IC chips.

FIG. 4 illustrates a chip-on-film (COF) structure in which the substrate SUB, the circuit members CCM, and the driving board 30 are connected sequentially in that order , but the disclosure is not limited thereto. As another example, a chip-on-plastic (COP) structure in which the driving board 30 are mounted directly on the substrate SUB without the circuit members CCM and the substrate SUB is bent may be provided. For example, the disclosure is not particularly limited as long as the driving board 30 is disposed on the rear surface of the display panel 10 and the vapor chamber 20 is disposed between the display panel 10 and the driving board 30.

The vapor chamber 20 may be disposed between the display panel 10 and the driving board 30. The vapor chamber 20 may be disposed at the rear of the display panel 10 and at the front of the driving board 30.

The term "rear", as used herein, refers to the first direction DR1, and the term "front", as used herein, refers to the opposite direction of the first direction DR1.

In some embodiments, the vapor chamber 20 may be in direct contact with the rear surface of the display panel 10. Accordingly, the heat generated from the display panel 10 may be transmitted to the vapor chamber 20.

As illustrated in the drawings, the vapor chamber 20 may be spaced apart from the driving board 30 with the supports SPT therebetween, but the disclosure is not limited thereto. As another example, in order to reduce the thickness of the display device 1 and improve the dissipation efficiency of the display device 1, the vapor chamber 20 may be in direct contact with the driving board 30 without the supports SPT, or the distance between the vapor chamber 20 and the driving board 30 may be minimized even in the presence of the supports SPT. Accordingly, the heat generated from the driving board 30 may be transmitted to the vapor chamber 20.

The vapor chamber 20 may dissipate the heat from the display panel 10 and the driving board 30 to another space in the display device 1 or to the outside of the display device 1.

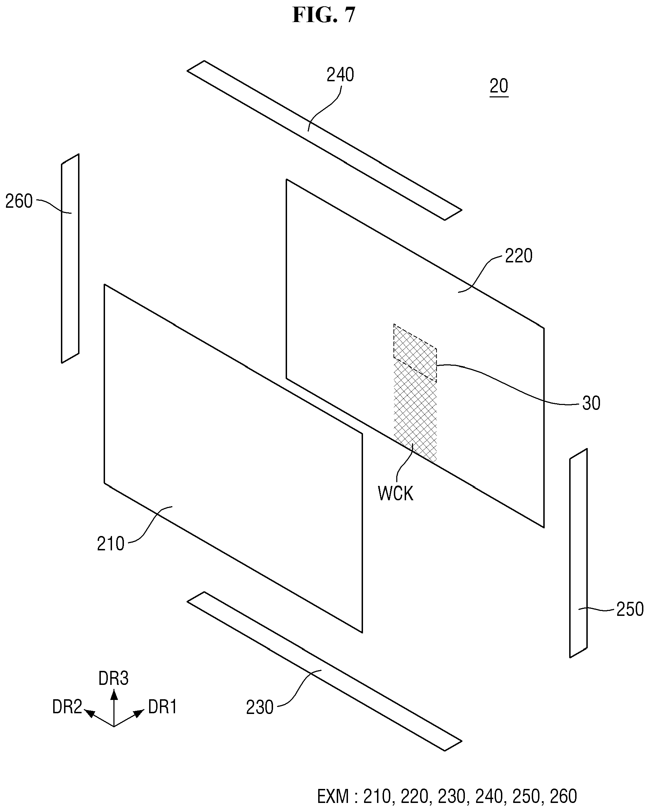

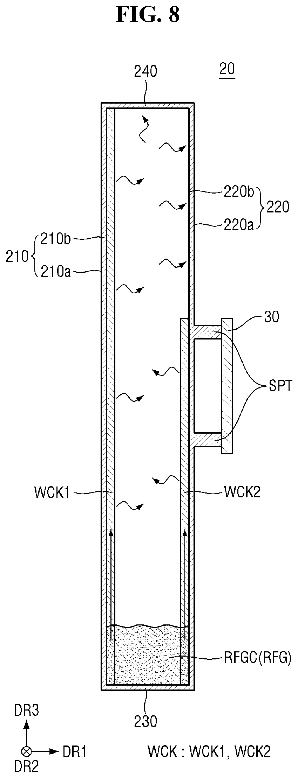

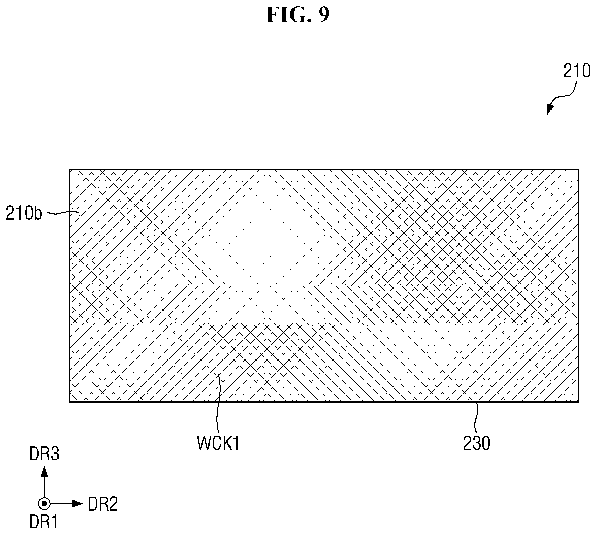

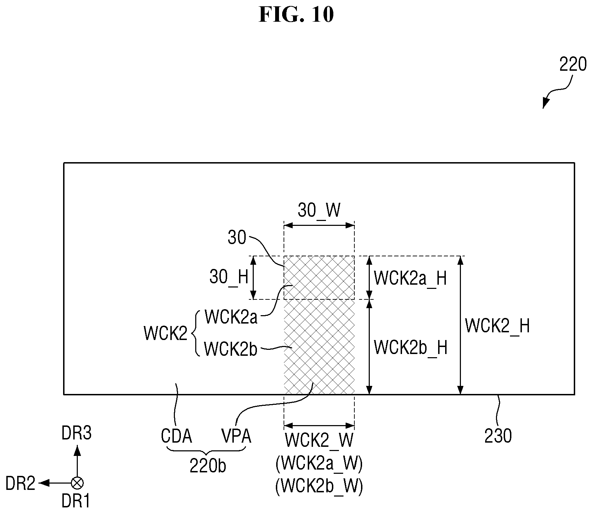

FIG. 6 is a schematic perspective view of a vapor chamber according to an embodiment of the disclosure. FIG. 7 is a schematic exploded perspective view of the vapor chamber of FIG. 6. FIG. 8 is a schematic cross-sectional view illustrating the vapor chamber of FIG. 6 and a driving board. FIG. 9 is a schematic rear view illustrating the rear surface of a front member of the vapor chamber of FIG. 6. FIG. 10 is a schematic front view illustrating the front surface of a rear surface of the vapor chamber of FIG. 6.

Referring to FIGS. 6 to 10, a vapor chamber 20 may include an external member EXM, wicks WCK, and a refrigerant RFG.

The external member EXM may partition an accommodation space in the vapor chamber 20 where the refrigerant RFG is interposed. The external member EXM may be formed of stainless steel (STS) or steel use stainless (SUS).

In some embodiments, the external member EXM may have a rectangular parallelepiped shape. For example, the exterior member EXM may include a front member 210 (or a first-surface member), a rear member 220 (or a second-surface member), a bottom member 230 (or a third-surface member), a top member 240 (or a fourth-surface member), a left member 250 (or a fifth-surface member), and a right member 260 (or a sixth-surface member).

Here, the term "front surface" refers to a surface as viewed in the first direction DR1, the term "rear surface" refers to a surface as viewed in the opposite direction of the first direction DR1, the term "left surface" refers to a surface as viewed in the second direction DR2, the term "right surface" refers to a surface as viewed in the opposite direction of the second direction DR2, the term "bottom surface" or "lower surface" refers to a surface as viewed in the third direction DR3, and the term "top surface" or "upper surface" refers to a surface as viewed in the opposite direction of the third direction DR3.

The external member EXM may be a single member having parts thereof physically connected to one another. For example, the front member 210, the rear member 220, the bottom member 230, the top member 240, the left member 250, and the right member 260 may be parts of a single member that are physically connected together, but the disclosure is not limited thereto. As another example, the front member 210, the rear member 220, the bottom member 230, the top member 240, the left member 250, and the right member 260 may be separate individual members and may be coupled together to form a single external member EXM.

An outer surface (or front surface) 210a of the front member 210 may directly face the display panel 100. An inner surface (or rear surface) 210b of the front member 210 may be in direct contact with the refrigerant RFG in the vapor member 20.

An outer surface (or rear surface) 220a of the rear member 220 may directly face the driving board 30. An inner surface (or front surface) 220b of the rear member 220 may be in direct contact with the refrigerant RFG in the vapor member 20.

A first wick WCK1 may be disposed on the entire inner surface 210b of the front member 210. A second wick WCK2 may be disposed on at least part of the inner surface 220b of the rear member 220. For example, the inner surface 220b of the rear member 220 may include a condensable area CDA (or a first area) where the second wick WCK2 is not disposed and a vaporizable area VPA (or a second area) where the second wick WCK2 is disposed.

In some embodiments, the condensable area CDA may adjoin the left, right, and upper edges of the vaporizable area VPA. For example, the condensable area CDA may be disposed to surround the left, right, and upper sides of the vaporizable area VPA.

The refrigerant RFG may be present in a liquid or gaseous state inside the vapor chamber 20. The refrigerant RFG may include a phase change material (PCM). The refrigerant RFG may absorb heat from an object in contact therewith, while vaporizing and may emit heat to the surroundings while condensing.

In some embodiments, when in a liquid state, the refrigerant RFG may be present mainly in a lower part of the vapor chamber 20, e.g., in a refrigerant dense part RFGC, which is positioned on the bottom member 230. More than 50% of the refrigerant, preferably more than 80% of the refrigerant may be present in the refrigerant dense part RFGC. The refrigerant RFG in the refrigerant dense part RFGC may move upward along the inner surfaces of the vapor chamber 20 through the wicks WCK. When in a gaseous state, the refrigerant RFG may circulate in the entire inner space of the vapor chamber 20.

The wicks WCK may have a capillary structure. For example, the wicks WCK may have a protruding shape. The wicks WCK may cause a capillary action such that the refrigerant RFG in lower parts of the wicks WCK may rise in a direction opposite to the direction of gravity.

The wicks WCK may include the first and second wicks WCK1 and WCK2.

The first wick WCK1 may be disposed on the inner surface 210b of the front member 210. The first wick WCK1 may be disposed in an entire area where the front member 210 overlaps the display panel 10. The first wick WCK1 may overlap the entire display panel 10. For example, the first wick WCK1 may be disposed on the entire inner surface 210b of the front member 210.

The second wick WCK2 may be disposed on the inner surface 220b of the rear member 220. The second wick WCK2 may be disposed in an area where at least the rear member 220 overlaps the driving board 30. The second wick WCK2 may overlap at least part of the driving board 30.

The second wick WCK2 may include a first portion WCK2a, which overlaps at least part of the driving board 30, and a second portion WCK2b, which does not overlap the driving board 30.

The first portion WCK2a may dissipate heat generated from the driving board 30, overlapping the driving board 30.

The second portion WCK2b may be disposed below the first portion WCK2a. For example, the second portion WCK2b may be disposed between the first portion WCK2a and the bottom member 230. The second portion WCK2b may extend to be adjacent to the bottom member 230.

The second portion WCK2b may be in direct contact with the refrigerant RFG in a liquid state. The second portion WCK2b may allow the refrigerant RFG in the refrigerant dense part RFGC to be able to move up to the first portion WCK2a.

In some embodiments, a width WCK2_W of the second wick WCK2 may be substantially equal to a width WCK2a_W of the first portion WCK2a and a width WCK2b_W of the second portion WCK2b. A height WCK2_H of the second wick WCK2 may be substantially equal to the sum of a height WCK2a_H of the first portion WCK2a and a height WCK2b_H of the second portion WCK2b.

The refrigerant RFG in a liquid state in the refrigerant dense part RFGC may move along the surface of the first wick WCK1 to be present on the entire inner surface 210b of the front member 210. The refrigerant RFG in a liquid state in the refrigerant dense part RFGC may move along the surface of the second wick WCK2 and may thus be present on part of the inner surface 220b of the rear member 220 where the second wick WCK2 is disposed, e.g., in the vaporizable area VPA.

In a case where heat generated from the display panel 10 as a result of the driving of the display panel 10 is transmitted to the front member 210, the refrigerant RFG in the first wick WCK1 may vaporize. In a case where heat generated from the driving board 30 as a result of the driving of the driving board 30 is transmitted to the rear member 220, the refrigerant RFG in the second wick WCK2 may vaporize. As the refrigerant RFG vaporizes, the refrigerant RFG may absorb the heat generated from the display panel 10 and the driving board 30.

The refrigerant RFG in a gaseous state may condense on the inner surfaces of the vapor chamber 20, which are at a relatively low temperature, circulating within the vapor chamber 20. For example, the refrigerant RFG in a gaseous state may condense in the condensable area CDA where the second wick WCK is not disposed. In another example, the refrigerant RFG in a gaseous state may condense even in part of the vaporizable area PVA where the second wick WCK2 is disposed and the temperature is relatively low because of the heat from the display panel 10 or the driving board 30 not being transmitted thereto. In yet another example, the refrigerant RFG in a gaseous state may condense on the bottom member 230, the top member 240, the left member 250, and the right member 260 where the wicks WCK of the vapor chamber 20 are not disposed. As the refrigerant RFG condenses, the heat from the display panel 10 and the driving board 30 may be dissipated to parts that do not overlap the display panel 10 and the driving board 30. In this manner, the vapor chamber 20 can dissipate the heat from the display panel 10 and the driving board 30.

As the wicks WCK are disposed not only on the front member 210, but also on the rear member 220, the display device 1 may efficiently dissipate not only the heat from the display panel 10, but also the heat from the driving board 30.

In some embodiments, the width WCK2a_W of the first portion WCK2a and the width WCK2b_W of the second portion WCK2b may be substantially equal to a width 30_W of the driving board 30. The height WCK2a_H of the first portion WCK2a may be substantially equal to a height 30_H of the driving board 30.

As the wicks WCK are disposed only on parts of the inner surfaces 220b of the rear member 220, e.g., only on the first and second portions WCK2a and WCK2b, a sufficient area for the condensation of the refrigerant RFG in a gaseous state can be secured. Accordingly, the display device 1 can improve a dissipation effect by promoting the circulation of the refrigerant RFG.

In an embodiment, the first and second wicks WCK1 and WCK2 may be spaced apart from each other. The refrigerant RFG may circulate in a liquid or gaseous state in the space between the first and second wicks WCK1 and WCK2. In a non-limiting example, the first and second wicks WCK1 and WCK2 may be parallel to each other.

In some embodiments, the area occupied by the first wick WCK1 on the inner surface 210b of the front member 210 may be greater than the area occupied by the second wick WCK2 on the inner surface 220b of the rear member 220.

The display panel 10 of the display device 1 may generate heat when emitting light, and the heat may be generated in the entire display area DPA of the display panel 10. Accordingly, the first wick WCK1, which is disposed on the front member 210 adjacent to the display panel 10, may be disposed in an entire area overlapping the display area DPA of the display panel 10. For example, the first wick WCK1 may be disposed on the entire inner surface 210b of the front member 210.

In contrast, as the driving board 30 overlaps only part of the rear member 210, the second wick WCK2, which is disposed on the rear member 220 adjacent to the driving board 30, may be disposed in a smaller area than the first wick WCK1.

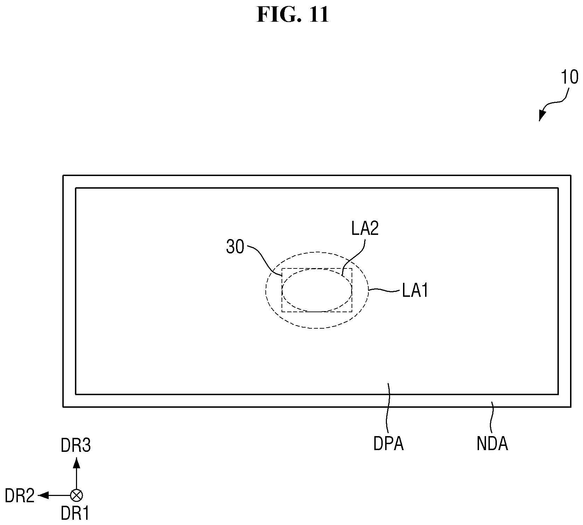

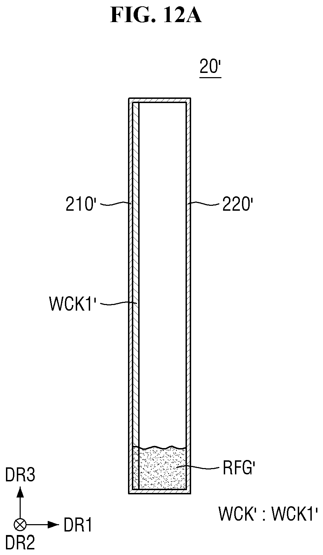

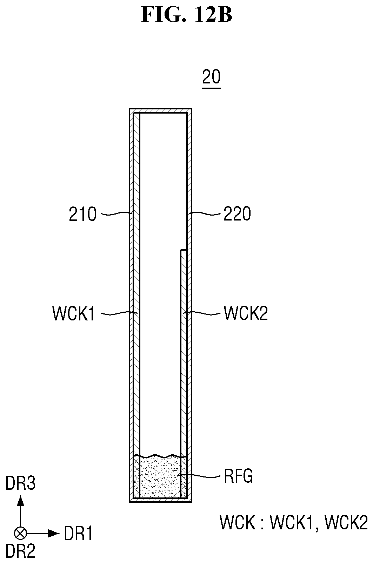

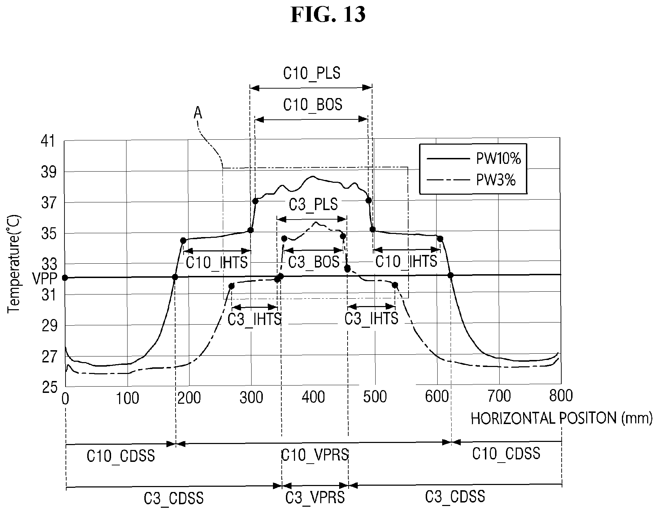

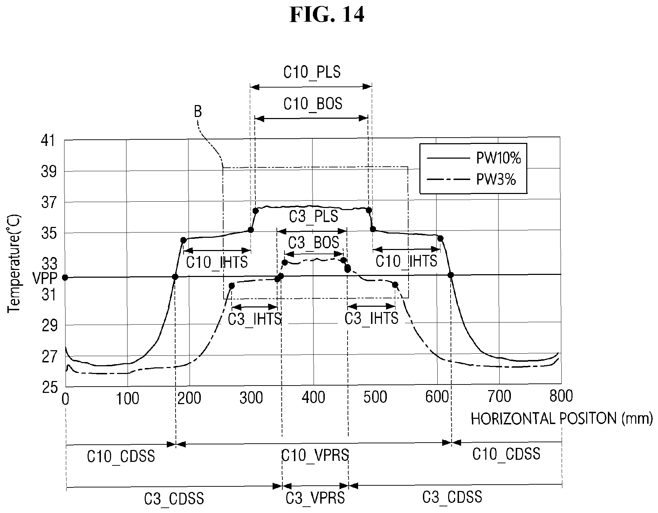

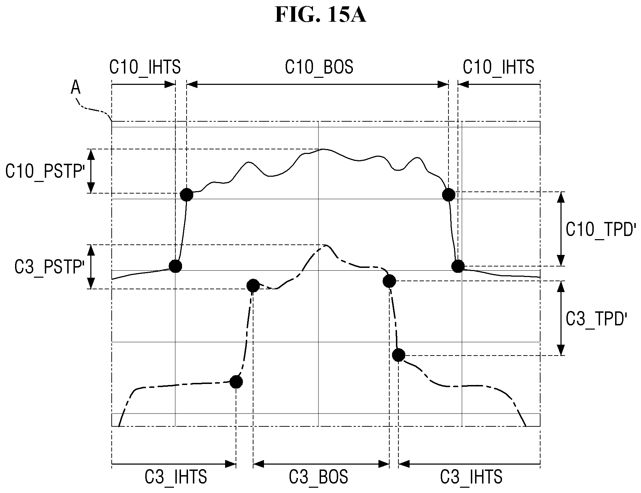

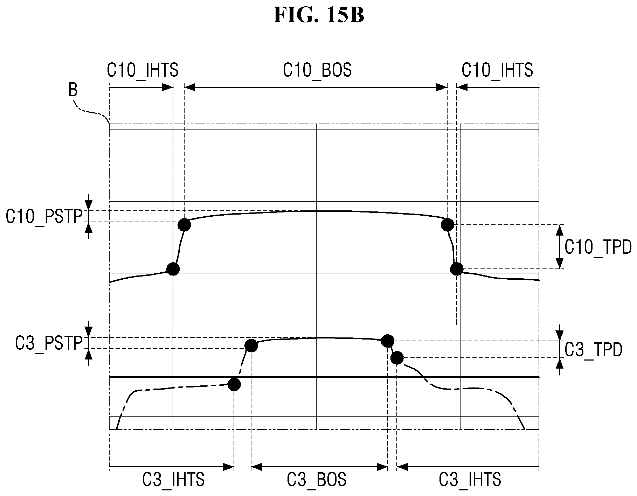

FIG. 11 is a schematic front view illustrating how a display panel according to an embodiment of the disclosure emits light. FIGS. 12A and 12B are schematic cross-sectional views comparing a conventional vapor chamber and the vapor chamber of FIG. 6. FIG. 13 is a schematic graph illustrating the distribution of temperatures in a display device including the conventional vapor chamber. FIG. 14 is a schematic graph illustrating the distribution of temperatures in a display device including the vapor chamber of FIG. 6. FIGS. 15A and 15B are schematic enlarged graphs illustrating parts A and B, respectively, of FIGS. 13 and 14.

Referring to FIGS. 11 to 15B, the display panel 10 may emit in the entire area thereof except for the non-display area NDA, e.g., in the entire display area DPA.

If necessary, the display panel 10 may emit light only in part of the display area DPA. For example, as illustrated in the drawings, the display panel 10 may emit light in a first emission area LA1 or in a second emission area LA2. The first and second emission areas LA1 and LA2 may be emission areas that are arbitrarily set to explain the graphs of FIGS. 13 to 15B.

The first emission area LA1 may overlap the driving board 30 and may be a larger size than the driving board 30. In an embodiment, the first emission area LA1 represents a case where the area of the pixels PX (see FIG. 2) emitting light in a peak white state is 10% of the total area of the pixels PX, which case is named PW10%.

The second emission area LA2 may overlap the driving board 30 and may be a smaller size than the driving board 30. In an embodiment, the second emission area LA2 represents a case where the area of the pixels PX emitting light in a peak white state is 3% of the total area of the pixels PX, which case is named PW3%.

Referring to FIG. 12A, a vapor chamber 20' of a conventional display device may have a wick WCK' disposed on a front member 210', but not on a rear member 220'. A refrigerant RFG' of the vapor chamber 20' may be movable along a first wick WCK1'.

In contrast, referring to FIG. 12B, the vapor chamber 20 of the display device 1 may have the wicks WCK disposed on the front and rear members 210 and 220. The refrigerant RFG of the vapor chamber 20 may be movable along the first and second wicks WCK1 and WCK2.

FIGS. 13 and 14 are schematic graphs illustrating the distribution of temperatures in the conventional display device and the display device 1, respectively. Specifically, FIG. 13 illustrates temperature distribution curves for the conventional display device for PW10% and PW3%, and FIG. 14 illustrates temperature distribution curves for the display device 1 for PW10% and PW3%. Referring to FIGS. 13 and 14, a position of 400 mm may correspond to the centers of the first and second emission areas LA1 and LA2 of the conventional display device or the display device 1.

In some embodiments, the temperature distribution curves for PW10% or PW3% may be generally symmetrical from left to right. The temperature may increase from both ends to the middle of each of the graphs of FIGS. 13 and 14.

Each of the temperature distribution curves for PW10% or PW3% may include condensation sections CDSS and a vaporization section VPRS. The condensation sections CDSS may be a section having temperatures lower than an average vaporization point VPP, and the vaporization section VPRS may be a section having temperatures higher than the average vaporization point VPP.

The average vaporization point VPP may refer to the average temperature at which the refrigerant RFG' or RFG begins to vaporize under given conditions. FIGS. 13 and 14 illustrates that the average vaporization point VPP may be, e.g., about 32°C, but the disclosure is not limited thereto.

For example, referring to the temperature distribution curves for PW10%, sections below about 180 mm and beyond about 620 mm may be condensation sections C10_CDSS, and sections between about 180 mm and about 620 mm may be vaporization sections C10_VPRS. For example, referring to the temperature distribution curves for PW3%, sections below about 350 mm and beyond about 450 mm may be condensation sections C3_CDSS, and sections between about 350 mm and about 450 mm may be vaporization sections C3_VPRS. However, the disclosure is not limited to these examples, and the condensation sections CDSS and the vaporization sections VPRS may vary depending on the average vaporization point VPP.

Each of the temperature distribution curves for PW10% or PW3% may further include a panel emission section PLS and a driving board overlap section BOS. The panel emission section PLS may be a section corresponding to the first and second emission areas LA1 and LA2, and the driving board overlap section BOS may be a section corresponding to the area of the driving board 30 of the conventional display device or the display device 1.

The panel emission section PLS may correspond to an area to which heat generated from the emission of light by the display panel 10 of the conventional display device or the display device 1 is directly transmitted, and the temperature of which changes directly due to heat generated from the display panel 10. The driving board overlap section BOS may correspond to an area to which heat generated from the driving of the driving board 30 is directly transmitted, and the temperature of which is changed by heat generated from the driving board 30.

The panel emission section PLS may refer to a section between points of rapid increases in temperature, in the middle of each of the temperature distribution curves for PW10% or PW3%. The driving board overlap section BOS may refer to a section in which a temperature is maintained at a level or repeatedly increases and decreases near a level, in the middle of each of the temperature distribution curves for PW10% or PW3%.

For example, referring to the temperature distribution curves for PW10%, sections between about 300 mm and about 500 mm may be panel emission sections C10_PLS. For example, referring to the temperature distribution curves for PW3%, sections between about 350 mm and about 450 mm may be panel emission sections C3_PLS. However, the disclosure is not limited to these examples, and the panel emission sections C10_PLS and the panel emission sections C3_PLS may vary depending on the first and second emission areas LA1 and LA2.

Each of the temperature distribution curves for PW10% or PW3% may further include indirect heat transmission sections IHTS. The indirect heat transmission sections IHTS may be sections in which the temperature changes indirectly due to thermal conduction of the heat from the display panel 10 or the driving board 30 by the external member EXM of the conventional display device or the display device 1.

The indirect heat transmission sections IHTS may be sections adjacent to both sides of the panel emission section PLS and may correspond to areas where the temperature is uniformly maintained. The temperature may slightly decrease away from the middle of the indirect heat transmission sections IHTS and may rapidly drop outside the indirect heat transmission sections IHTS.

For example, referring to the temperature distribution curves for PW10%, sections between about 190 mm and about 300 mm or between about 500 mm and about 610 mm may be indirect heat transmission sections C10_IHTS. For example, referring to the temperature distribution curves for PW3%, sections between about 270 mm and about 350 mm or between about 450 mm and about 520 mm may be indirect heat transmission sections C3_IHTS. However, the disclosure is not limited to these examples. The indirect heat transmission sections IHTS may vary depending on the thermal conductivity of the exterior member EXM.

FIG. 15A is a schematic enlarged graph illustrating the panel emission sections PLS and the driving board overlap sections BOS of the conventional display device, and FIG. 15B is a schematic enlarged graph illustrating the panel emission sections PLS and the driving board overlap sections BOS of the display device 1.

Temperature differences TPD' between the driving board overlap sections BOS and the indirect heat transmission sections IHTS of the conventional display device may be greater than temperature differences TPD between the driving board overlap sections BOS and the indirect heat transmission sections IHTS of the display device 1.

For example, referring to the temperature distribution curves for PW10%, a temperature difference C10_TPD' between a driving board overlap section C10_BOS and the indirect heat transmission sections C10_IHTS of the conventional display device may be greater than a temperature difference C10_TPD between the driving board overlap section C10_BOS and the indirect heat transmission sections C10_IHTS of the display device 1. For example, referring to the temperature distribution curves for PW3%, a temperature difference C3_TPD' between a driving board overlap section C3_BOS and the indirect heat transmission sections C3_IHTS of the conventional display device may be greater than a temperature difference C3_TPD between the driving board overlap section C3_BOS and the indirect heat transmission sections C3_IHTS of the display device 1.

A profile difference PSTP' in the driving board overlap section BOS of the conventional display device may be greater than a profile difference PSTP in the driving board overlap section BOS of the display device 1.

Here, the term "profile difference" may refer to the difference between maximum and minimum temperatures in each driving board overlap section.

For example, referring to the temperature distribution curves for PW10%, a profile difference C10_PSTP' in the driving board overlap section C10_BOS of the conventional display device may be greater than a profile difference C10_PSTP in the driving board overlap section C10_BOS of the display device 1. For example, referring to the temperature distribution curves for PW3%, a profile difference C3_PSTP' in the driving board overlap section C3_BOS of the conventional display device may be greater than a profile difference C3_PSTP in the driving board overlap section C3_BOS of the display device 1.

The driving board overlap section BOS of the display device 1 may generally be even. For example, the driving board overlap section BOS of the conventional display device may be uneven due to increases and decreases in temperature, but the driving board overlap section BOS of the display device 1 may generally be even because of no significant increases or decreases in temperature.

For example, referring to the temperature distribution curves for the conventional display device for PW10% and PW3%, the temperature continues to vary in the driving board overlap sections C10_BOS and C3_BOS of the conventional display device, but referring to the temperature distribution curves for the display device 1 for PW10% and PW3%, the temperature is generally uniform in the driving board overlap sections C10_BOS and C3_BOS of the display device 1.

As the wicks WCK are disposed even on the rear member 220 of the vapor chamber 20, the profile differences C3_PSTP and C10_PSTP can be reduced, and the temperature differences C3_TPD and C10_TPD can be reduced. As a result, not only the heat generated from the display panel 10, but also the heat generated from the driving board 30 can be effectively dissipated.

Vapor chambers according to other embodiments of the disclosure will hereinafter be described, focusing on the differences with the vapor chamber of FIG. 6. Like reference numerals and reference characters indicate like elements throughout the disclosure, and thus, detailed descriptions thereof will be omitted.

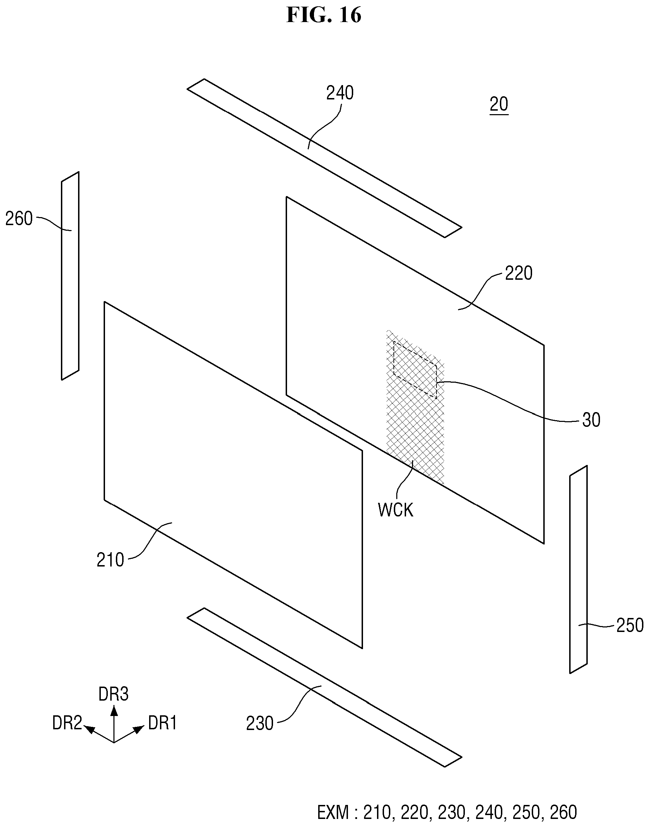

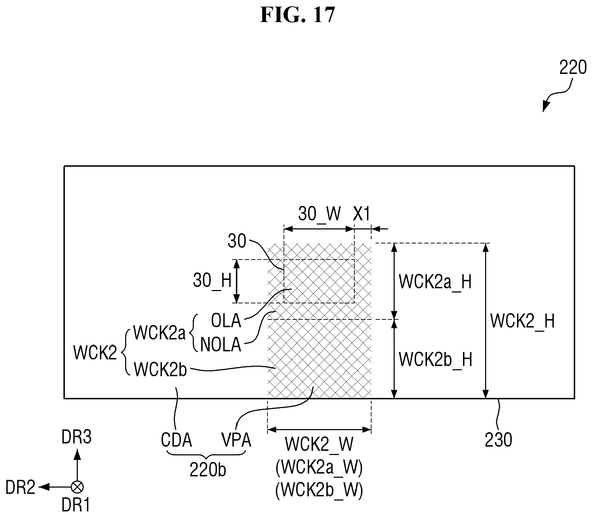

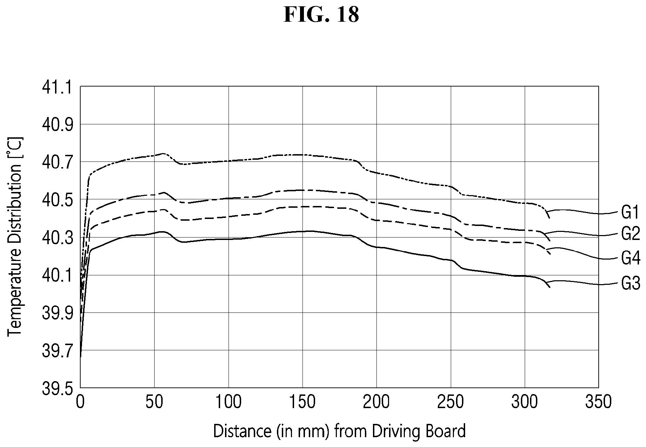

FIG. 16 is a schematic exploded perspective view of a vapor chamber according to another embodiment of the disclosure. FIG. 17 is a schematic front view illustrating the front surface of a rear member of the vapor chamber of FIG. 16. FIG. 18 is a schematic graph illustrating the distribution of temperatures depending on the width of a non-overlap area of a first portion of a second wick.

Referring to FIGS. 16 to 18, a vapor chamber 20 may differ from the vapor chamber 20 described with reference to FIGS. 6 and 7 or the like at least in that the width of the second wick WCK2 is greater than that of a driving board 30.

Specifically, the second wick WCK2 may include a first portion WCK2a, which overlaps at least part of the driving board 30, and a second portion WCK2b, which does not overlap the driving board 30.

The first portion WCK2a may include an overlap area OLA, which overlaps the driving board 30, and a non-overlap area NOLA, which does not overlap the driving board 30. The non-overlap area NOLA may be an area expanded from the overlap area OLA by a first width (or first expansion) X1 in second and third directions DR2 and DR3.

In some embodiments, the area of the first portion WCK2a may be greater than the area of the driving board 30. A width WCK2a_W of the first portion WCK2a and a width WCK2b_W of the second portion WCK2b may be greater than a width 30_W of the driving board 30. For example, the width WCK2a_W of the first portion WCK2a and the width WCK2b_W of the second portion WCK2b may be about two times greater than the first width X1.

A height WCK2a_H of the first portion WCK2a may be greater than a height 30_H of the driving board 30. For example, the height WCK2a_H of the first portion WCK2a may be greater than the height 30_H of the driving board 30 by two times the first width X1.

Heat generated from the driving board 30 may be directly or indirectly transmitted not only to an area overlapping the driving board 30, but also to areas around the area overlapping the driving board 30. Also, a vaporizable area VPA of a wick WCK can be enlarged by making the width WCK2_W and the height WCK2_H of the second wick WCK2 greater than the width 30_W and the height 30_H of the driving board 30. Accordingly, the vaporization of a refrigerant RFG can be promoted, and as a result, the dissipation of heat can be improved.

In some embodiments, the first width X1 may be about 50 mm to about 150 mm. For example, the first width X1 may be about 100 mm.

Referring to FIG. 18, each of first, second, third, and fourth curves G1, G2, G3, and G4 illustrates the distribution of temperatures depending on the distance from the driving board 30.

Specifically, the first curve G1 corresponds to a case where the first width X1 is about 0 mm, the second curve G2 corresponds to a case where the first width X1 is about 50 mm, the third curve G3 corresponds to a case where the first width X1 is about 100 mm, and the fourth graph G4 corresponds to a case where the first width X1 is about 150 mm.

At a given distance from the driving board 30, the first graph G1 illustrates a distribution of higher temperatures than the second graph G2, the second graph G2 illustrates a distribution of higher temperatures than the fourth graph G4, and the fourth graph G4 illustrates a distribution of higher temperatures than the third graph G3.

In case that the first width X1 is about 50 mm or greater, a sufficient vaporizable area VPA can be secured, and in case that the first width X1 is about 150 mm or less, a sufficient condensable area CDA can be secured. Accordingly, the vaporization and condensation of the refrigerant RFG can be appropriately promoted, and as a result, the dissipation of heat can be improved.

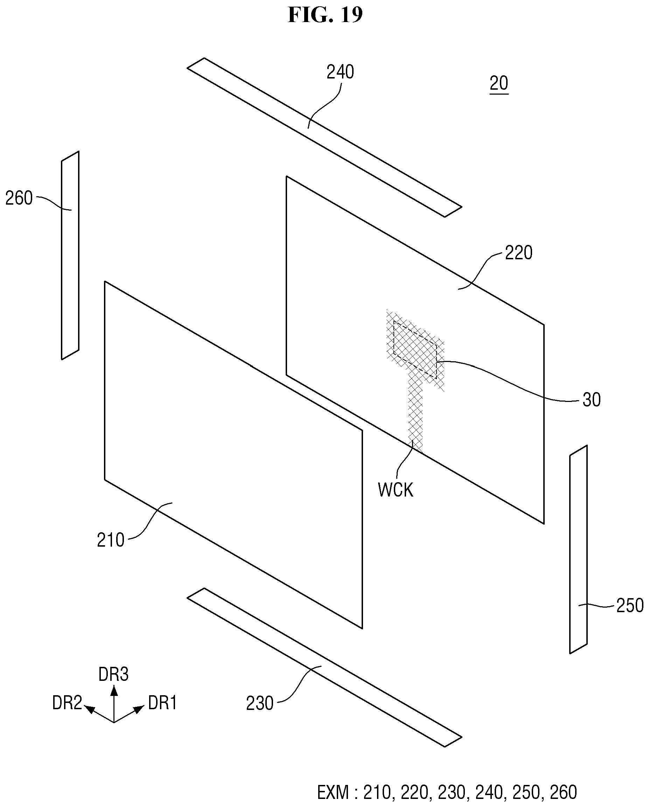

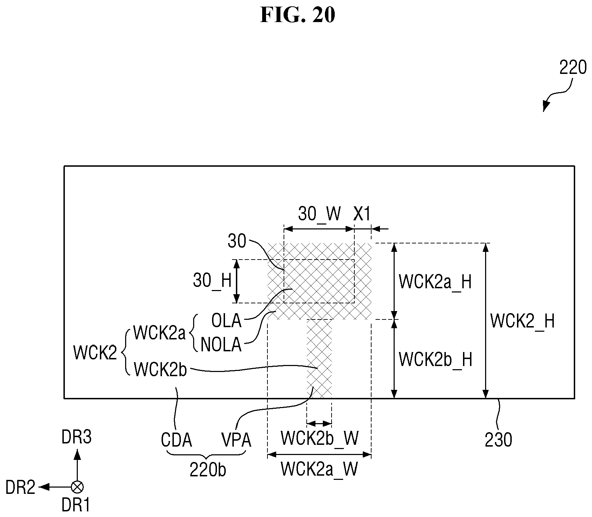

FIG. 19 is a schematic exploded perspective view of a vapor chamber according to another embodiment of the disclosure. FIG. 20 is a schematic front view illustrating the front surface of a rear member of the vapor chamber of FIG. 19.

Referring to FIGS. 19 and 20, a vapor chamber 20 may differ from the vapor chamber 20 described with reference to FIG. 16 or the like at least in that a width WCK2b_W of a second portion WCK2b is less than a width WCK2a_W of a first portion WCK2a.

Specifically, an inner surface 220b of a rear member 220 may include a condensable area CDA (e.g., a first area) where a second wick WCK2 is not disposed and a vaporizable area VPA (e.g., a second area) where the second wick WCK2 is disposed.

The condensable area CDA may adjoin the left, right, and upper edges of the vaporizable area VPA. In an embodiment, the condensable area CDA may adjoin at least part of the lower edge of the first portion WCK2a.

The width WCK2b_W of the second portion WCK2b may be less than the width WCK2a_W of the first portion WCK2a. In an embodiment, the left and right edges of the first portion WCK2a may protrude beyond the left and right edges, respectively, of the second portion WCK2b in a second direction DR2.

The second portion WCK2b may allow a refrigerant RFG in a refrigerant dense part RFGC to be movable up to a first portion WCK2a. As the second portion WCK2b does not overlap a driving board 30, the second portion WCK2b may be an area where the refrigerant RFG does not vaporize. Thus, the condensable area CDA can be widened by forming the width WCK2b_W of the second portion WCK2b to be less than the width WCK2a_W of the second portion WCK2a. Accordingly, the circulation of the refrigerant RFG can be promoted, and as a result, the dissipation of heat can be improved.

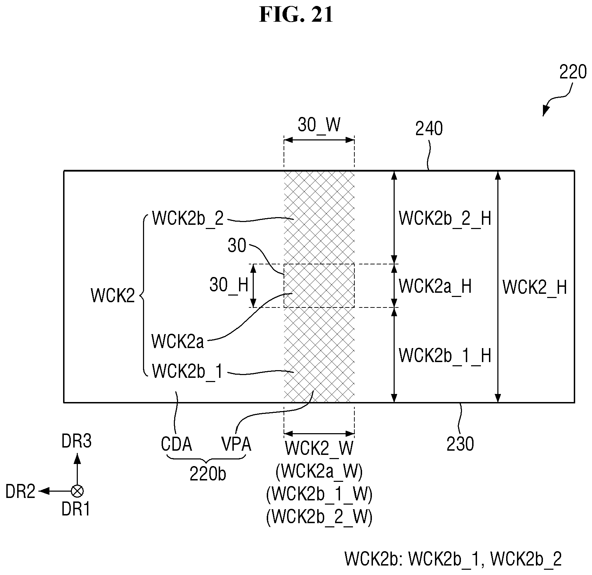

FIG. 21 is a schematic front view illustrating the front surface of a rear member of a vapor chamber according to another embodiment of the disclosure.

Referring to FIG. 21, a vapor chamber 20 differs from the vapor chamber 20 described with reference to FIG. 10 or the like at least in that a second wick WCK2 extends to be adjacent to a top member 240.

Specifically, the second wick WCK2 may include a first portion WCK2a, which overlaps at least part of a driving member 30, and a second portion WCK2b, which does not overlap the driving board 30.

The second portion WCK2b may include a (2-1)-th portion WCK2b_1, which is disposed below the first portion WCK2a, and a (2-2)-th portion WCK2b_2, which is disposed above the first portion WCK2a.

The (2-1)-th portion WCK2b_1 may be disposed between the first portion WCK2a and a bottom member 230. The (2-1)-th portion WCK2b_1 may extend to be adjacent to the bottom member 230. The (2-2)-th portion WCK2b_2 may be disposed between the first portion WCK2a and the top member 240. The (2-2)-th portion WCK2b_2 may extend to be adjacent to the top member 240.

In some embodiments, a width WCK2_W of the second wick WCK2 may be substantially equal to a width WCK2a_W of the first portion WCK2a, a width WCK2b_1_W of the (2-1)-th portion WCK2b_1, and a width WCK2b_2_W of the (2-2)-th portion WCK2b_2. A height WCK2_H of the second wick WCK2 may be the sum of a height WCK2a_H of the first portion WCK2a, a height WCK2b_1_H of the (2-1)-th portion WCK2b_1, and a height WCK2b_2_H of the (2-2)-th portion WCK2b_2.

As the (2-2)-th portion WCK2b_2 is further provided, a vaporizable area VPA can be widened. Accordingly, the circulation of a refrigerant RFG can be promoted, and as a result, the dissipation of heat can be improved.

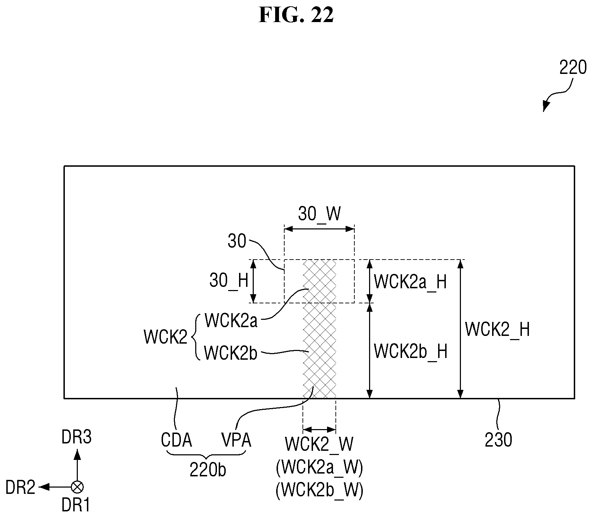

FIG. 22 is a schematic front view illustrating the front surface of a rear member of a vapor chamber according to another embodiment of the disclosure.

Referring to FIG. 22, a vapor chamber 20 may differ from the vapor chamber 20 described with reference to FIG. 10 or the like at least in that a second wick WCK2 is narrower than a driving board 30.

Specifically, the second wick WCK2 may include a first portion WCK2a, which overlaps at least part of the driving board 30, and a second portion WCK2b, which does not overlap the driving board 30.

In some embodiments, the area of a first portion WCK2a may be less than the area of the driving board 30. For example, a width WCK2a_W of the first portion WCK2a and a width WCK2b_W of the second portion WCK2b may be less than a width 30_W of the driving board 30.

As the second wick WCK2b is disposed only in an area overlapping part of the driving board 30 where most heat is generated, a sufficient area for a refrigerant RFG in a gaseous state to condense can be secured. Accordingly, the circulation of the refrigerant RFG can be promoted, and as a result, the dissipation of heat can be improved.

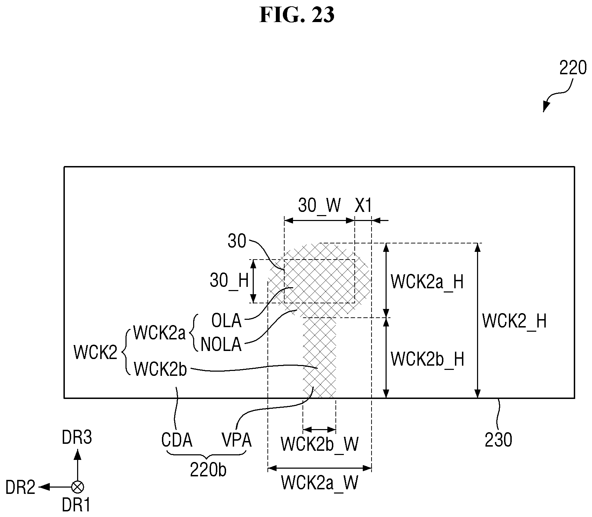

FIG. 23 is a schematic front view illustrating the front surface of a rear member of a vapor chamber according to another embodiment of the disclosure.

Referring to FIG. 23, a vapor chamber 20 may differ from the vapor chamber 20 described with reference to FIG. 16 or the like at least in that a first portion WCK2a has a different shape from a driving board 30.

Specifically, the shape of the first portion WCK2a may be different from the shape of the driving board 30.

In some embodiments, the first portion WCK2a may have a symmetrical shape. For example, the first portion WCK2a may have an elliptical or circular shape. In another example, the first portion WCK2a may have a polygonal shape such as a rhombus or a parallelogram. However, the shape of the first portion WCK2a is not limited to these examples. For example, the first portion WCK2 may be formed in various other shapes depending on the direction in which heat spreads and the location of a heat-generating part of the driving board 30, and may not have a symmetrical shape.

As the second wick WCK2 may be disposed in an area that receives heat from the driving board 30, as large a condensable area CDA as possible can be secured, and the size of a vaporizable area VPA can be controlled. Accordingly, the circulation of a refrigerant RFG can be promoted, and as a result, the dissipation of heat can be improved.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the disclosure, but to describe the disclosure, and the scope of the disclosure is not limited by these embodiments. The protection scope of the disclosure should be interpreted by the following claims.
Further aspects and/or embodiments of the present invention will be disclosed below using the following numbering Aspect 1 to Aspect 15.
1. A display device (1) comprising:
   a display panel (10);
   a driving board (30) disposed on a side of the display panel (10); and
   a vapor chamber (20) disposed between the display panel (10) and the driving board, wherein
   the vapor chamber (20) includes:
      an external member (EXM);
      a first wick (WCK1) and a second wick (WCK2) which are disposed on at least parts of inner surfaces (210b, 220b) of the external member and face each other;
      a refrigerant (RFG) which is contained in the external member; and
      a refrigerant dense part (RFGC) in which the refrigerant is densely present, and
   an area occupied by the first wick on the inner surfaces (210b, 220b) of the external member is greater than an area occupied by the second wick on the inner surfaces (210b, 220b) of the external member.
2. The display device (1) of aspect 1, wherein
   the second wick (WCK2) includes:
      a first portion (WCK2a) which overlaps at least part of the driving board (30); and
      a second portion (WCK2b) which does not overlap the driving board and is disposed below the first portion, and
   the second portion is in direct contact with the refrigerant dense part (RFGC).
3. The display device (1) of aspect 2, wherein an area of the first portion (WCK2a) is greater than an area of the driving board (30).
4. The display device (1) of aspect 2 or 3, wherein
   a width and a height of the first portion (WCK2a) are greater than a width and a height of the driving board (30), respectively, by a first expansion (X1) , and
   the first expansion is in a range of 50 mm to 150 mm.
5. The display device (1) of any of aspects 2 to 4, wherein a width of the second portion (WCK2b) is less than a width of the first portion (WCK2a).
6. The display device (1) of any of aspects 2 to 5, wherein
   the external member (EXM) includes:
      a first-surface member (210) and a second-surface member (220) which are opposite to each other; and
      a third-surface member (230) which intersects the first- and second-surface members,
   the first wick (WCK1) is disposed on a first surface of the first-surface member (210) and the second wick (WCK2) is disposed on a first surface of the second-surface member,
   the first wick (WCK1) is disposed on the entire first surface of the first-surface member (210), and
   the second wick (WCK2) is disposed on at least part of the first surface of the second-surface member (220) and extends to be adjacent to the third-surface member (230).
7. The display device (1) of aspect 6, wherein
   the external member (EXM) further includes a fourth-surface member (240) which is opposite to the third-surface member (230),
   the second wick (WCK2) further includes a third portion which is disposed between the first portion and the fourth-surface member, and
   the third portion does not overlap the driving board and extends to be adjacent to the fourth-surface member.
8. The display device (1) of aspect 1, wherein
   the first wick (WCK1) overlaps the entire display panel (10), and
   the second wick (WCK2) overlaps the entire driving board.
9. The display device (1) of aspect 8, wherein a width of the second wick is equal to a width of the driving board (30).
10. The display device (1) of aspect 1 , wherein a width of the second wick is less than a width of the driving board (30).
11. A vapor chamber (20) comprising:
   an external member (EXM) including a first-surface member (210) and a second-surface member (220) which are opposite to each other;
   a first wick (WCK1) disposed on a first surface of the first-surface member and a second wick (WCK2) disposed on a first surface of the second-surface member, , the first and second wicks (WCK1, WCK2) facing each other;
   a refrigerant (RFG) contained in the external member; and
   a refrigerant dense part (RFGC) in which the refrigerant is densely present,
   wherein the first surface of the second-surface member includes a first area where the second wick (WCK2) is not disposed and a second area where the second wick (WCK2) is disposed,
   an area occupied by the first wick (WCK1) on the first surface of the external member is greater than an area occupied by the second wick (WCK2) on the first surface of the external member, and
   the first area adjoins left and right edges of the second area.
12. The vapor chamber of aspect 11, wherein the first area adjoins the left and right edges and an upper edge of the second area, or, wherein the first area adjoins only the left and right edges of the second area.
13. The vapor chamber of aspect 11 or 12, wherein
   the refrigerant dense part (RFGC) is in contact with the first and second wicks (WCK1, WCK2),
   the second wick (WCK2) includes:
      a first portion (WCK2a) which does not overlap the refrigerant dense part; and
      a second portion (WCK2b) which overlaps at least part of the refrigerant dense part and is disposed below the first portion,
   left and right edges of the first portion (WCK2a) protrude beyond left and right edges of the second portion, respectively, and
   the first area adjoins at least part of a lower edge of the first portion.
14. The vapor chamber of any of aspects 12 to 13, wherein a width of the second portion is less than a width of the first portion.
15. The vapor chamber of any of aspects 11 to 14, wherein
   the external member (EXM) further includes:
      a third-surface member (230) which intersects the first- and second-surface members, and
   a fourth-surface member (240) which is opposite to the third-surface member,
   the second wick (WCK2) further includes a third portion which is disposed between the first portion and the fourth-surface member, and
   the third portion is disposed above the first portion and extends to be adjacent to the fourth-surface member.

## Claims

1. A display device (1) comprising:
a display panel (10);
a driving board (30) disposed on the display panel (10); and
a vapor chamber (20) disposed between the display panel (10) and the driving board (30), wherein
the vapor chamber (20) includes:
a first wick (WCK1) disposed adjacent to the display panel (10);
a second wick (WCK2) disposed on adjacent to the driving board (30); and
a refrigerant (RFG) in at least a portion of contact with the first wick (WCK1) and the second wick (WCK2), and
an area the first wick (WCK1) is greater than an area of the second wick (WCK2).

2. The display device (1) of claims 1, wherein
the second wick (WCK2) includes:
a first portion (WCK2a) which overlaps at least part of the driving board (30); and
a second portion (WCK2b) which does not overlap the driving board and is disposed below the first portion, and
the second portion is in direct contact with the refrigerant (RFG).

3. The display device (1) of claim 2, wherein an area of the first portion (WCK2a) is greater than an area of the driving board (30).

4. The display device (1) of claim 2 or 3, wherein
a width and a height of the first portion (WCK2a) are greater than a width and a height of the driving board (30), respectively, by a first expansion (X1), and
the first expansion is in a range of 50 mm to 150 mm.

5. The display device (1) of any of claims 2 to 4, wherein a width of the second portion (WCK2b) is less than a width of the first portion (WCK2a).

6. The display device (1) of any of claims 2 to 5, wherein
the vapor chamber (20) further includes an external member (EXM),
the external member (EXM) includes:
a first-surface member (210) and a second-surface member (220) which are opposite to each other; and
a third-surface member (230) which intersects the first- and second-surface members,
the first wick (WCK1) is disposed on a first surface of the first-surface member (210) and the second wick (WCK2) is disposed on a first surface of the second-surface member,
the first wick (WCK1) is disposed on the entire first surface of the first-surface member (210), and
the second wick (WCK2) is disposed on at least part of the first surface of the second-surface member (220) and extends to be adjacent to the third-surface member (230).

7. The display device (1) of claim 6, wherein
the external member (EXM) further includes a fourth-surface member (240) which is opposite to the third-surface member (230),
the second wick (WCK2) further includes a third portion which is disposed between the first portion and the fourth-surface member, and
the third portion does not overlap the driving board and extends to be adjacent to the fourth-surface member.

8. The display device (1) of claim 1, wherein
the first wick (WCK1) overlaps the entire display panel (10), and
the second wick (WCK2) overlaps the entire driving board.

9. The display device (1) of claim 8, wherein a width of the second wick is equal to a width of the driving board (30).

10. The display device (1) of claim 1, wherein a width of the second wick is less than a width of the driving board (30).

11. A vapor chamber (20) comprising:
an external member (EXM);
a first wick (WCK1) and a second wick (WCK2) disposed on at least parts of inner surfaces (210b, 220b) of the external member and face each other, the first and second wicks (WCK1, WCK2) facing each other;
a refrigerant (RFG) contained in the external member; and
a refrigerant dense part (RFGC) in which the refrigerant is densely present,
wherein
an area of the first wick (WCK1) is greater than an area of the second wick (WCK2).

12. The vapor chamber of claim 11, wherein
the external member includes a first surface member (210) and a second surface member (220) which are opposite to each other,
the first wick (WCK1) is disposed on a first surface (210b) of the first surface member (210),
the second wick (WCK2) is disposed on a first surface (220b) of the second surface member (220),
the first surface of the second surface member includes a first area where the second wick (WCK2) is not disposed and a second area where the second wick (WCK2) is disposed, and
the first area adjoins left and right edges of the second area.

13. The vapor chamber of claim 11 or 12, wherein
the refrigerant dense part (RFGC) is in contact with the first and second wicks (WCK1, WCK2),
the second wick (WCK2) includes:
a first portion (WCK2a) which does not overlap the refrigerant dense part; and
a second portion (WCK2b) which overlaps at least part of the refrigerant dense part and is disposed below the first portion,
left and right edges of the first portion (WCK2a) protrude beyond left and right edges of the second portion, respectively, and
the first area adjoins at least part of a lower edge of the first portion.

14. The vapor chamber of any of claims 11 to 13, wherein a width of the second portion is less than a width of the first portion.

15. An electronic device comprising a display device,
wherein the display device comprising:
a display panel (10);
a driving board (30) disposed on the display panel (10); and
a vapor chamber (20) disposed between the display panel (10) and the driving board (30), wherein
the vapor chamber (20) includes:
a first wick (WCK1) disposed adjacent to the display panel (10);
a second wick (WCK2) disposed on adjacent to the driving board (30) ; and
a refrigerant (RFG) in at least a portion of contact with the first wick (WCK1) and the second wick (WCK2) , and
wherein an area of the first wick (WCK1)is greater than an area of the second wick (WCK2).
